# EUROPÄISCHE PATENTSCHRIFT

(11) **EP 0 278 484 B1**
(45) Veröffentlichungstag und Bekanntmachung des Hinweises auf die Patenterteilung: **18.08.1993**
(21) Anmeldenummer: 88101904.6
(22) Anmeldetag: 10.02.1988
(51) Int. Cl.: G06K 11/06, H05K 3/46, H05K 3/40

(54) **Verfahren zur Herstellung eines Digitalisiertabletts**
Process for making a digitalization board
Méthode de fabrication d'une plaquette utilisée pour la digitalisation

(30) Priorität: 13.02.1987 DE 3704498
(43) Veröffentlichungstag der Anmeldung: 17.08.1988
(73) Patentinhaber: Aristo Graphic Systeme GmbH & Co KG, D-22525 Hamburg (DE)
(72) Erfinder: Schrodt, Hans-Joachim, D-2000 Hamburg 55 (DE)

(56) Entgegenhaltungen:
- FR-A- 2 296 347
- GB-A- 2 078 448
- GB-A- 2 127 979
- GB-A- 2 157 085
- US-A- 3 573 755

## Beschreibung

Die Erfindung bezieht sich auf ein Verfahren zur Herstellung eines Digitalisiertabletts mit zwei Gruppen von jeweils innerhalb der Gruppe parallelen Leiterbahnen, die senkrecht zueinander verlaufen und fast koplanar angeordnet sind, bei dem die Leiterbahnen einer Gruppe jeweils durch Ätzen aus einer Metallschicht, insbesondere Kupferschicht, hergestellt werden, dann eine Isolierschicht unter Aussparung entsprechender Kontaktierungsbereiche aufgebracht wird und anschließend mittels elektrisch leitfähiger oder metallisierbarer Druckfarben weitere Leiterstrukturen vorgesehen sind.

Bei einem bekannten Verfahren dieser Art (FR-A 2 296 347 = DE-OS 25 58 367) ergibt sich das Problem, daß die Isolierschicht durchgend auf Leiterbahnabschnitte und diesen benachbarte Bereiche des Basismaterials aufgebracht werden, wobei infolge des Höhenüberstandes der Leiterbahnen über das Basismaterial eine Oberfläche erhalten wird, die nicht eben ist. Dies ist für viele Anwendungsfälle nachteilig.

Es ist Aufgabe der Erfindung Verfahren zur Herstellung von Digitalisiertabletts dahingehend zu verbessern, daß sich nach dem Auftragen des Isoliermaterials eine durchgehend ebene Isolierschicht ergibt.

Zur Lösung dieser Aufgabe wird ein Verfahren gemäß Oberbegriff des Anspruchs 1 durch die Merkmale des kennzeichnenden Teils dieses Anspruches ausgestaltet.

Bei dem erfindungsgemäßen Verfahren erfolgt das Aufbringen der Isolierschicht in zwei Schritten, wobei zunächst eine erste Isolierschicht aufgebracht wird, die lediglich die Bereiche zwischen den Leiterbahnen und den Kontkatierungsflächen bedeckt und die die gleiche Dicke wie die Leiterbahnhöhe hat, so daß eine ebene Fläche entsteht, die teilweise von der Oberfläche der ersten Isolierschicht und teilweise von den Oberflächen der Leiterbahnen und der Kontaktierungsflächen gebildet wird. Auf diese ebene Fläche wird dann unter Freilassung der Kontaktierungsflächen eine durchgehende Isolierstoffschicht aufgetragen, so daß auf diese Weise eine ebene Oberfläche erhalten wird.

Weitere Ausgestaltungen der Erfindung ergeben sich aus den Unteransprüchen.

Die Erfindung wird im folgenden anhand der Figuren näher erläutert.
- Figur 1: zeigt in einer vereinfachten Draufsicht den Leiterbahn- und den Verbindungsverlauf eines Digitalisiertabletts.
- Figur 2: zeigt in einer Teil-Explosionsdarstellung den Aufbau des Digitalisiertabletts im in Figur 1 strichpunktiert umrandeten Bereich.

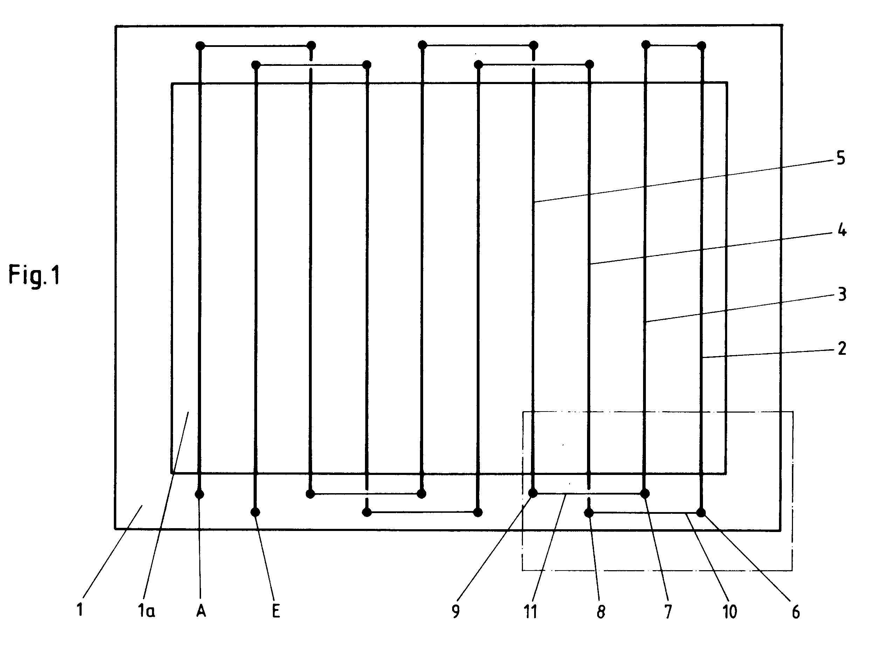

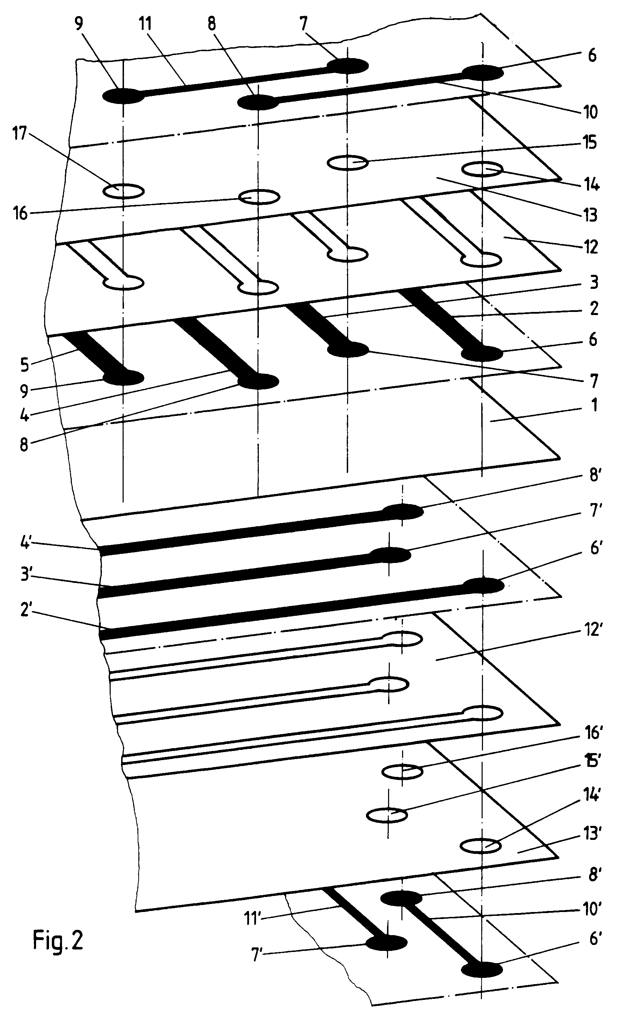

Das in Figur 1 schematisch dargestellte Digitalisiertablett hat eine aus einem Kunststoffträger bestehende Hauptfläche 1, auf der, wie durch eine Umrandung angedeutet, eine Arbeitsfläche 1a gebildet ist. Auf dieser Arbeitsfläche befinden sich parallel zueinander verlaufende, in gleichem Abstand voneinander angeordnete Leiterbahnen, von denen die sich teilweise in das strichpunktiert umrandete Feld erstreckenden Leiterbahnen mit den Bezugszeichen 2, 3, 4 und 5 bezeichnet sind. Die Enden einander nicht unmittelbar benachbarter Leiterbahnen, etwa die Enden 6 und 8 sowie 7 und 9 der Leiterbahnen 2, 4 bzw. 3, 5 sind durch Verbindungen, etwa 10 und 11 miteinander verbunden, wobei wie in Figur 1 zu erkennen ist, die oberen, nicht bezeichneten Enden der benachbarten Leiterbahnen 2 und 3 direkt miteinander verbunden sind. Alle Verbindungen sowie auch der Anfang A und das Ende E des auf diese Weise gebildeten Leitungsverlaufes liegen außerhalb der Arbeitsfläche 1a, und man erkennt, daß ein am Anfang A des Leitungsverlaufes zugeführter Impuls nacheinander alle Verbindungen und Leiterbahnen durchläuft, bis er am Ende E des Leitungsverlaufes austritt. Mittels eines oder mehrerer derartiger Impulse erfolgt in bekannter Weise die Ermittlung von bestimmten Punkten oder Bereichen auf der Arbeitsfläche 1a möglich, wobei zu berücksichtigen ist, daß an der Unterseite der Fläche 1 eine ähnliche, jedoch um 90° gedrehte Anordnung von Leiterbahnen und Verbindungen vorgesehen ist, wie dies auch Figur 2 zu entnehmen ist.

In Figur 2 ist der die Fläche 1 bildende Kunststoffträger ohne die auf ihm angeordneten Leiterbahnen 2, 3, 4, 5 gemäß Figur 1 und ohne die an der Unterseite der Fläche 1 vorgesehenen Leiterbahnen 2', 3', 4' dargestellt.

In diesem Zusammenhang sei erwähhnt, daß die in Figur 2 angedeutete Anordnung unterhalb der Fläche 1 im wesentlichen der Anordnung oberhalb der Fläche 1 entspricht, jedoch um 90° gedreht ist. Gleiche Bauelemente und Teile sind mit gleichen Bezugszeichen wie oberhalb der Fläche 1, jedoch zusätzlich mit ' gekennzeichnet und brauchen wegen der Übereinstimmung mit dem Aufbau oberhalb der Fläche 1 nicht näher erläutert zu werden.

Die Leiterbahnen 2, 3, 4, 5 einschließlich ihrer Kontaktierungsflächen bildender Enden 6, 7, 8, 9 werden in üblicher Weise durch Ätztechnik, etwa aus Kupfer auf der Fläche 1 ausgebildet. Danach wird auf diese Fläche, etwa im Siebdruckverfahren eine Isolierstoffbeschichtung 12 aufgetragen, die jedoch weder die Leiterbahnen 2, 3, 4, 5 noch deren Enden 6, 7, 8, 9 abdeckt, sondern lediglich den Bereich zwischen diesen bis genau zur Höhe der Leiterbahnen 2, 3, 4, 5 ausfüllt, so daß eine durchgehend ebene Fläche entsteht. Auf diese Fläche wird dann, wiederum vorzugsweise im Siebdruckverfahren eine Isolierstoffschicht 13 aufgebracht, die jedoch Aussparungen 14, 15, 16, 17 im Bereich der Leiterbahnenden 6, 7, 8, 9 aufweist, so daß die Isolierstoffschicht 13 die gesamte erste Isolierstoffbeschichtung 12 und die Leiterbahnen 2, 3, 4, 5 elektrisch isolierend abdeckt, jedoch die Enden 6, 7, 8, 9 freiläßt.

Schließlich werden auf die Isolierstoffschicht 13 mittels bekannter, elektrisch leitfähiger oder metallisierbarer Druckfarbe die Verbindungen 10, 11 aufgedruckt, wobei bei diesem Druckvorgang auch der Anschluß dieser Verbindungen 10, 11 mit den Leiterbahnenden 6, 8 und 7, 9 hergestellt wird, da diese durch die Aussparungen 14, 16 und 15, 17 hindurch zugänglich sind, während die aufgedruckten Verbindungen 10, 11 in ihrem übrigen Verlauf gegenüber den Leiterbahnen durch die Isolierstoffschicht 13 elektrisch isoliert sind.

## Patentansprüche

1. Verfahren zur Herstellung eines Digitalisiertabletts mit zwei Gruppen von jeweils innerhalb der Gruppe parallelen Leiterbahnen ( 2,3,4,5,2',3',4'), die senkrecht zueinander verlaufen und fast koplanar angeordnet sind, bei dem die Leiterbahnen (2,3,4,5,2',3',4') einer Gruppe jeweils durch Ätzen aus einer Metallschicht, insbesondere Kupferschicht hergestellt werden, dann eine Isolierschicht (13,13') unter Aussparung entsprechender Kontaktierungsbereiche (6,7,8,9,6',7',8') aufgebracht wird und anschließend mittels elektrisch leitfähiger oder metallisierbarer Druckfarben weitere Leiterstrukturen vorgesehen sind, **dadurch gekennzeichnet, daß** auf die die Leiterbahnen (2,3,4,5,2',3',4') einer Gruppe tragende Fläche (1) eine die Leiterbahnen (2,3,4,5,2',3',4') freilassende Isolierstoffbeschichtung (12,12') aufgebracht wird, deren Dicke gleich der Dicke der Leiterbahnen (2,3,4,5,2',3',4') ist, und daß die Isolierstoffschicht (13,13') auf die Leiterbahnen (2,3,4,5,2',3',4') und die Isolierstoffbeschichtung (12,12') aufgebracht wird.

2. Verfahren nach Anspruch 1, **dadurch gekennzeichnet,** daß die Isolierstoffbeschichtung (12; 12') im Siebdruckverfahren aufgebracht wird.

3. Verfahren nach einem der Ansprüche 1 bis 2, **dadurch gekennzeichnet,** daß die Isolierstoffschicht (13; 13') im Siebdruckverfahren aufgebracht wird.

4. Verfahren nach einem der Ansprüche 1 bis 3, **dadurch gekennzeichnet,** daß die Druckfarbe im Siebdruckverfahren aufgedruckt wird.

## Claims

1. A method for producing a digitising tablet with two groups of conductive tracks (2, 3, 4, 5, 2', 3', 4') each parallel within the group which extend at right-angles to one another and are arranged in coplanar manner, in which the conductive tracks (2, 3, 4, 5, 2', 3', 4') of a group are each produced by etching from a metal layer, in particular copper layer, then a layer of insulating material (13, 13') is applied by leaving free corresponding contact regions (6, 7, 8, 9, 6', 7', 8') and afterwards by means of electrically conductive or metallisable printing inks further conductive structures are provided, characterised in that a coating of insulating material (12; 12') which leaves the conductive tracks (2, 3, 4, 5, 2', 3', 4') free is applied to the surface (1) bearing the conductive tracks (2, 3, 4, 5, 2', 3', 4') of a group, the thickness of which coating is equal to the thickness of the conductive tracks (2, 3, 4, 5, 2', 3', 4'), and that the layer of insulating material (13, 13') is applied to the conductive tracks (2, 3, 4, 5, 2', 3', 4') and to the coating of insulating material (12, 12').

2. A method according to Claim 1, characterised in that the coating of insulating material (12; 12') is applied in a screen printing process.

3. A method according to one of Claims 1 to 2, characterised in that the layer of insulating material (13; 13') is applied in a screen printing process.

4. A method according to one of Claims 1 to 3, characterised in that the printing ink is printed in a screen printing process.

## Revendications

1. Procédé de production d'une tablette numérique avec deux groupes de pistes, les pistes (2, 3, 4, 5, 2', 3', 4') étant parallèles à l'intérieur de chaque groupe, les groupes sont perpendiculaires et coplanaires, et on obtient les pistes (2, 3, 4, 5, 2', 3', 4') d'un groupe par gravure chimique d'une couche métallique, notamment une couche de cuivre, ensuite on dépose une couche d'isolant (13,13') en laissant libres des zones de contact correspondantes (6, 7, 8, 9, 6', 7', 8') et après au moyen des encres d'imprimerie électriquement conductrices ou métallisables d'autres structures conductrices sont prévues, procédé caractérisé en ce qu'on dépose un revêtement d'isolant (12,12') laissant libres des pistes (2, 3, 4, 5, 2', 3', 4') sur la surface (1) portant les pistes (2, 3, 4, 5, 2', 3', 4') d'un groupe, revêtement dont l'épaisseur est égale à l'épaisseur des pistes (2, 3, 4, 5, 2', 3', 4') et en ce qu'on dépose la couche d'isolant(13, 13') sur les pistes (2, 3, 4, 5, 2', 3', 4') et le revêtement d'isolant (12, 12').

2. Procédé selon la revendication 1,caractérisé en ce que le revêtement d'isolant (12; 12') est déposé par procédé de sérigraphie.

3. Procédé selon l'une des revendications 1 à 2, caractérisé en ce que la couche d'isolant (13; 13') est déposée par procédé de sérigraphie.

4. Procédé selon l'une des revendications 1 à 3, caractérisé en ce qu'on imprime l'encre d'imprimerie par procédé de sérigraphie.
